(19) Europäisches Patentamt / European Patent Office / Office européen des brevets

(11) **EP 4 020 530 A1**

(12) **DEMANDE DE BREVET EUROPEEN**

(43) Date de publication:
**29.06.2022 Bulletin 2022/26**

(21) Numéro de dépôt: **21214254.1**

(22) Date de dépôt: **14.12.2021**

(51) Classification Internationale des Brevets (IPC):
**H01L 21/56** (2006.01)    **H01L 23/31** (2006.01)
**H01L 23/485** (2006.01)    **H01L 23/495** (2006.01)
**H02M 7/00** (2006.01)    *H02M 7/5387* (2007.01)

(52) Classification Coopérative des Brevets (CPC):
(C-Sets disponibles)
**H01L 23/315; H01L 21/565; H01L 23/49524;**
**H01L 23/49541; H01L 23/49562; H01L 23/49575;**
**H01L 24/40; H01L 24/48; H02J 4/00; H02M 7/003;**
H01L 24/37; H01L 24/45; H01L 2224/0603;
H01L 2224/32245; H01L 2224/37124;     (Cont.)

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**
Etats d'extension désignés:
**BA ME**
Etats de validation désignés:
**KH MA MD TN**

(30) Priorité: **22.12.2020 FR 2013916**

(71) Demandeur: **VALEO EQUIPEMENTS ELECTRIQUES MOTEUR**
**94046 Créteil Cedex (FR)**

(72) Inventeurs:
• **VERCAMBRE, Virginie**
**94046 CRETEIL CEDEX (FR)**
• **KRIKEB, Mohammed**
**94046 CRETEIL CEDEX (FR)**
• **DUTOT, Antoine**
**95892 CERGY PONTOISE (FR)**
• **MASSOL, Laurent**
**94046 CRETEIL CEDEX (FR)**

(74) Mandataire: **Valeo Powertrain Systems**
**Service Propriété Intellectuelle**
**Immeuble le Delta**
**14, avenue des Béguines**
**95892 Cergy Pontoise (FR)**

(54) **MODULE DE PUISSANCE AVEC SURMOULAGE ET SYSTEMES COMPRENANT UN TEL MODULE DE PUISSANCE**

(57) L'invention concerne un module de puissance comprenant :
• une première et une deuxième pièces de connexion électrique, de préférence en métal, présentant chacune une plaque principale ($306_1$, $306_2$), les plaques principales ($306_1$, $306_2$) s'étendant selon un même plan principal de manière à être sensiblement coplanaires ;
• un transistor ($112_1$) monté sur une face supérieure de la plaque principale ($306_1$) de la première pièce de connexion électrique, la face supérieure du transistor ($112_1$) définissant un plan de référence (P), ledit transistor ($112_1$) étant connecté électriquement par au moins un rubans ($326_1$) ou par un au moins un fil à la face supérieure de la plaque principale ($306_2$) de la deuxième pièce de connexion électrique ; et
• un surmoulage isolant électrique (402), par exemple en résine, recouvrant ledit transistor ($112_1$) et au moins une partie de la face supérieure de la plaque principale ($306_1$, $306_2$) de la première et de la deuxième pièces de connexion électrique, la face supérieure du surmoulage isolant électrique (402) présentant une cavité (C1) située au moins partiellement au-dessus du ruban ($326_1$) ou du fil ;

ledit module de puissance étant caractérisé en ce que ladite cavité (C1) est à fond plat, en ce que le ruban ($326_1$) ou le fil forme un premier pont ($PO_1$) dont les deux extrémités reposent à plat sur la face supérieure du transistor ($112_1$), en ce que la projection orthogonale du point le plus élevé du premier pont ($PO_1$) sur le plan de référence (P) est incluse dans la projection orthogonale dudit fond plat de la cavité (C1) sur le plan de référence (P) et dans lequel la différence entre la distance D5 entre le point le plus élevé du premier pont ($PO_1$) par rapport au plan de référence (P) et l'épaisseur (D4) du ruban ($326_1$) ou du fil est supérieure ou égale à la différence entre la distance D3 entre le plan parallèle au plan de référence passant par ledit point le plus élevé du surmoulage isolant électrique (402) et le plan de référence (P) et la distance D2 entre le plan parallèle au plan de référence passant par le point le plus élevé du surmoulage isolant électrique (402) et le plan parallèle au plan de référence passant par le point le moins élevé de ladite cavité (C1).

    **(Cont. page suivante)**

EP 4 020 530 A1

[Fig. 6]

(52) Classification Coopérative des Brevets (CPC):
(Cont.)
H01L 2224/37144; H01L 2224/40132;
H01L 2224/40245; H01L 2224/45014;
H01L 2224/45015; H01L 2224/45124;
H01L 2224/45144; H01L 2224/48132;
H01L 2224/48245; H01L 2224/48247;
H01L 2224/4903; H01L 2224/49051;
H01L 2224/73221; H01L 2224/73263;
H01L 2224/73265; H01L 2924/1815;
H02M 7/5387

C-Sets
H01L 2224/37124, H01L 2924/2076;
H01L 2224/37144, H01L 2924/2076;
H01L 2224/45015, H01L 2924/2076;
H01L 2224/45124, H01L 2924/00014;
H01L 2224/45144, H01L 2924/00014

**Description**

La présente invention concerne un module de puissance avec surmoulage, un système électrique et un convertisseur de tension comprenant un tel module de puissance.

Un module de puissance est un module électronique, contenant le plus souvent des puces semi-conductrices (par exemple des transistors dit de puissance), conçu pour réaliser des circuits de conversion d'énergie, comme ceux par exemple d'une cellule de commutation, d'un onduleur ou encore d'un pont redresseur.

Il est connu de l'art antérieur des modules de puissance comprenant :

- une première et une deuxième pièces de connexion électrique, de préférence en métal, présentant chacune une plaque principale, les plaques principales s'étendant selon un même plan principal de manière à être sensiblement coplanaires ;
- un transistor monté sur une face supérieure de la plaque principale de la première pièce de connexion électrique, la face supérieure du transistor définissant un plan de référence, ledit transistor étant connecté électriquement par au moins un rubans ou par un au moins un fil à la face supérieure de la plaque principale de la deuxième pièce de connexion électrique ; et
- un surmoulage isolant électrique, par exemple en résine, recouvrant ledit transistor et au moins une partie de la face supérieure de la plaque principale de la première et de la deuxième pièces de connexion électrique, la face supérieure du surmoulage isolant électrique présentant une cavité située au moins partiellement au-dessus du ruban ou du fil.

Or, en cas de surchauffe du transistor, par exemple en cas de court-circuit, la chaleur se diffuse dans l'isolant électrique de sorte que celui-ci risque de prendre feu, mettant en péril les éléments environnants.

L'invention a pour but de pallier au moins en partie le problème précité.

Il est donc proposé, selon un premier aspect de l'invention, un module de puissance comprenant :

- une première et une deuxième pièces de connexion électrique, de préférence en métal, présentant chacune une plaque principale, les plaques principales s'étendant selon un même plan principal de manière à être sensiblement coplanaires ;
- un transistor monté sur une face supérieure de la plaque principale de la première pièce de connexion électrique, la face supérieure du transistor définissant un plan de référence, ledit transistor étant connecté électriquement par au moins un rubans ou par un au moins un fil à la face supérieure de la plaque principale de la deuxième pièce de connexion électrique ; et

- un surmoulage isolant électrique, par exemple en résine, recouvrant ledit transistor et au moins une partie de la face supérieure de la plaque principale de la première et de la deuxième pièces de connexion électrique, la face supérieure du surmoulage isolant électrique présentant une cavité située au moins partiellement au-dessus du ruban ou du fil.

Ce module de puissance est caractérisé en ce que ladite cavité est à fond plat, en ce que le ruban ou le fil forme un premier pont dont les deux extrémités reposent à plat sur la face supérieure du transistor, en ce que la projection orthogonale du point le plus élevé du premier pont sur le plan de référence est incluse dans la projection orthogonale dudit fond plat de la cavité sur le plan de référence et dans lequel la différence entre la distance D5 entre le point le plus élevé du premier pont par rapport au plan de référence et l'épaisseur du ruban ou du fil est supérieure ou égale à la différence entre la distance D3 entre le plan parallèle au plan de référence passant par ledit point le plus élevé du surmoulage isolant électrique et le plan de référence et la distance D2 entre le plan parallèle au plan de référence passant par le point le plus élevé du surmoulage isolant électrique et le plan parallèle au plan de référence passant par le point le moins élevé de ladite cavité.

Le fait que la cavité soit située au moins partiellement au-dessus du ruban ou du fil signifie géométriquement que l'intersection entre la projection orthogonale du ruban ou du fil sur le plan principal et la projection orthogonale de la cavité sur ce même plan principal est non vide.

Grâce à cette caractéristique technique, l'épaisseur du surmoulage isolant électrique est ajustée en fonction de l'agencement du ruban ou du fil de sorte que cette épaisseur soit moindre, voire nulle au-dessus du ruban ou du fil.

En outre, la relation entre les distances D5, D2, D3 et l'épaisseur du ruban ou du fil permet de garantir que l'extrémité haute du premier pont formé par le ruban ou le fil se situe dans la cavité de sorte que le surmoulage isolant électrique exerce peu voire aucune force de maintien sur cette extrémité haute.

De cette façon, la force de maintien du surmoulage isolant électrique exercée sur le ruban ou fil, et en particulier sur l'extrémité haute est diminuée ce qui permet une rupture plus facile de ce ruban ou fil lorsqu'il s'échauffe.

Ainsi, le ruban ou fil dans le module de puissance selon l'invention se rompt à une température plus faible que celui dans le module de puissance selon l'art antérieur. Grâce à cette rupture à une température plus faible, l'échauffement du transistor est limité.

En d'autres termes, la température du surmoulage isolant électrique du module de puissance selon l'invention reste plus faible en cas de défaut de fonctionnement du transistor que dans le module de puissance selon l'art antérieure de sorte que le module de puissance selon l'invention risque moins de prendre feu.

Un module de puissance selon l'invention peut en outre comporter une ou plusieurs des caractéristiques optionnelles suivantes, prises isolément ou bien selon n'importe quelle combinaison techniquement possible.

Selon une autre caractéristique, la différence entre la distance D3 et la distance D2 est supérieure ou égale à l'épaisseur du ruban ou du fil, de préférence supérieure ou égale à deux fois l'épaisseur du ruban ou du fil.

La relation entre les distances D2, D3 et l'épaisseur du ruban ou du fil permet de garantir l'existence d'une épaisseur de résine minimale au-dessus du transistor se sorte que le transistor soit correctement protégé par la résine.

Selon une autre caractéristique, la cavité est à fond plat et le module de puissance est caractérisé en ce que la projection orthogonale du point le plus élevé du ruban ou du fil sur le plan de référence soit incluse dans la projection orthogonale du fond plat sur le plan de référence et en ce que la différence entre la distance D1 entre le point le plus élevé du ruban ou du fil par rapport au plan de référence et l'épaisseur du ruban ou du fil soit supérieure ou égale à la différence entre la distance D3 et la distance D2.

Selon une autre caractéristique, le ruban ou fil forme un deuxième pont dont une extrémité repose à plat sur la face supérieure du transistor et dont l'autre extrémité repose à plat sur la face supérieure de la plaque principale de la deuxième pièce de connexion électrique, la projection orthogonale du point le plus élevé du deuxième pont sur le plan de référence est incluse dans la projection orthogonale du fond plat de la cavité sur le plan de référence et la différence entre la distance D6 entre le point le plus élevé du deuxième pont par rapport au plan de référence et l'épaisseur du ruban ou du fil est supérieure ou égale à la différence entre la distance D3 et la distance D2.

Selon une autre caractéristique, le transistor est connecté par une pluralités de rubans et/ou de fils à la face supérieure de la plaque principale de la deuxième pièce de connexion électrique et la cavité est à fond plat, le module de puissance étant caractérisé en outre en ce que la projection orthogonale du point le plus élevé de chaque ruban et/ou fil sur le plan de référence soit incluse dans la projection orthogonale du fond plat de la cavité sur le plan de référence et en ce que pour chaque ruban et/ou fil, la différence entre la distance entre le point le plus élevé de ce ruban et/ou fil par rapport au plan de référence et l'épaisseur de ce ruban ou fil soit supérieure ou égale à la différence entre la distance D3 et la distance D2

Selon une autre caractéristique, la cavité est située au moins partiellement au-dessus de la partie la plus élevée du ruban ou du fil.

Selon une autre caractéristique, la cavité est située au moins partiellement au-dessus du premier pont.

Selon une autre caractéristique, la cavité est située au moins partiellement au-dessus du deuxième pont.

Selon une autre caractéristique, la première pièce de connexion électrique est destinée à être connectée à une borne positive d'une source de tension continue.

Selon une autre caractéristique, la deuxième pièce de connexion électrique est destinée à être connectée à une phase d'une machine électrique tournante.

Selon une autre caractéristique, la première pièce de connexion électrique comprend au moins un connecteur électrique se projetant depuis sa plaque principale.

Selon une autre caractéristique, le connecteur électrique de la première pièce de connexion électrique se projette depuis la plaque principale de la première pièce de connexion électrique dans le plan principal.

Selon une autre caractéristique, le connecteur électrique et la plaque principale de la première pièce de connexion électrique le portant sont réalisés en une seul pièce par continuité de matière.

Selon une autre caractéristique, la deuxième pièce de connexion électrique comprend au moins un connecteur électrique se projetant depuis sa plaque principale.

Selon une autre caractéristique, le connecteur électrique de la deuxième pièce de connexion électrique se projette depuis la plaque principale de la deuxième pièce de connexion électrique dans le plan principal.

Selon une autre caractéristique, le connecteur électrique et la plaque principale de la deuxième pièce de connexion électrique le portant sont réalisés en une seul pièce par continuité de matière.

Selon une autre caractéristique, le transistor est connecté électriquement à la face supérieure de la plaque principale de la première pièce de connexion électrique.

Selon une autre caractéristique, le surmoulage isolant électrique est intégral en une seule pièce.

Selon une autre caractéristique, la cavité est remplie de gel ou d'une résine présentant une dureté moindre que celle du surmoulage isolant électrique

Selon une autre caractéristique, le transistor est un transistor de type FET (de l'anglais « Field-Effect Transistor ») ou de type IGBT (de l'anglais « Insulated-Gate Bipolar Transistor »).

Selon une autre caractéristique, le transistor de type FET est un MOSFET en silicium (Si-MOSFET) ou en carbure de silicium (SiC-MOSFET) ou est un transistor FET en nitrure de gallium (GaN-FET).

Selon une autre caractéristique, le transistor est un transistor HEMT (de l'anglais « high-electron-mobility transistor ») par exemple en nitrure de gallium.

Selon une autre caractéristique, le transistor à la forme d'une plaque, par exemple sensiblement rectangulaire, présentant une face supérieure et une face inférieure.

Selon une autre caractéristique, le transistor présente une face inférieure plaquée contre la face supérieure de la plaque principale de la première pièce de connexion électrique sur laquelle le transistor est monté.

Selon une autre caractéristique, le transistor est connecté électriquement à la face supérieure de la plaque principale de la première pièce de connexion électrique par l'intermédiaire de sa face inférieure.

Selon une autre caractéristique, le surmoulage présente un plot de résine se projetant vers le bas

Selon une autre caractéristique, les plaques principales sont séparées les unes des autres selon le plan principal par au moins un interstice et le surmoulage remplit chaque interstice et présente, dans chaque interstice, une face inférieure affleurant des faces inférieures des plaques principales.

Selon une autre caractéristique, le plot de résine se projette depuis la face inférieure du surmoulage présent dans l'interstice.

Selon une autre caractéristique, les pièces de connexion électrique sont obtenues par découpage d'une seule plaque métallique.

Selon une autre caractéristique, le surmoulage laisse apparent au moins une partie de la face inférieure de la plaque principale d'au moins une des pièces de connexion électrique, cette partie laissée apparente étant conçue pour être plaquée contre un dissipateur thermique.

Selon une autre caractéristique, la cavité est au moins partiellement découpée par ablation laser dans la face supérieure du surmoulage isolant électrique.

Il est à noter que la relation entre les distances D2, D3 et D4 permet également de garantir qu'une couche suffisante de résine se trouve entre le fond de la cavité et le transistor de sorte que le transistor n'est pas endommagé lors de l'ablation laser de la cavité.

Selon une autre caractéristique, la cavité est à fond plat.

Selon une autre caractéristique, le fond plat de la cavité est constitué de plusieurs marches situées à des niveaux différents.

Selon une autre caractéristique, le fond de la cavité est plat à l'exception d'une portion en saillie située sous le ruban ou le fil.

Selon une autre caractéristique, le fond de la cavité est plat à l'exception d'une portion en saillie située sous chaque ruban et/ou chaque fil.

Selon une autre caractéristique, la portion en saillie s'élève depuis le fond plat de la cavité.

Selon un deuxième aspect de l'invention, il est également proposé un système électrique comprenant un dissipateur thermique et un module de puissance selon le premier aspect de l'invention, et dans lequel le dissipateur thermique est en contact thermique avec la face inférieure laissée apparente par le surmoulage.

Selon un troisième aspect de l'invention, il est également proposé convertisseur de tension comprenant un module de puissance selon le premier aspect de l'invention ou bien un système électrique selon le deuxième aspect de l'invention.

Ce convertisseur de tension est destiné à être connecté entre une source d'alimentation électrique délivrant une tension continue et une machine électrique tournante pour effectuer une conversion entre la tension continue de la source d'alimentation électrique et au moins une tension de phase de la machine électrique tournante.

L'invention sera mieux comprise à l'aide de la description qui va suivre, donnée uniquement à titre d'exemple et faite en se référant aux dessins annexés dans lesquels :

[Fig. 1] la figure 1 représente schématiquement un système électrique comportant un convertisseur de tension mettant en œuvre l'invention dans un premier mode de réalisation de l'invention,

[Fig. 2] la figure 2 est une vue éclatée en trois dimensions du convertisseur de tension de la figure 1 dans un premier mode de réalisation de l'invention,

[Fig.3] la figure 3 est une vue en trois dimensions de dessus d'un module de puissance du convertisseur de tension de la figure 2, sans surmoulage dans le premier mode de réalisation de l'invention,

[Fig.4] la figure 4 est une vue similaire à celle de la figure 3, avec surmoulage,

[Fig.5] la figure 5 est une vue en trois dimensions de dessous du module de puissance des figures 3 et 4, avec surmoulage,

[Fig.6] la figure 6 est une vue schématique décrivant les relations existantes entre certaines dimensions physiques d'un module de puissance dans le premier mode de réalisation de l'invention, et

[Fig.7] la figure 7 est une vue schématique décrivant les relations existantes entre certaines dimensions physiques d'un module de puissance dans un deuxième mode de réalisation de l'invention.

[Fig.8] la figure 8 est une vue schématique décrivant les relations existantes entre certaines dimensions physiques d'un module de puissance dans un troisième mode de réalisation de l'invention.

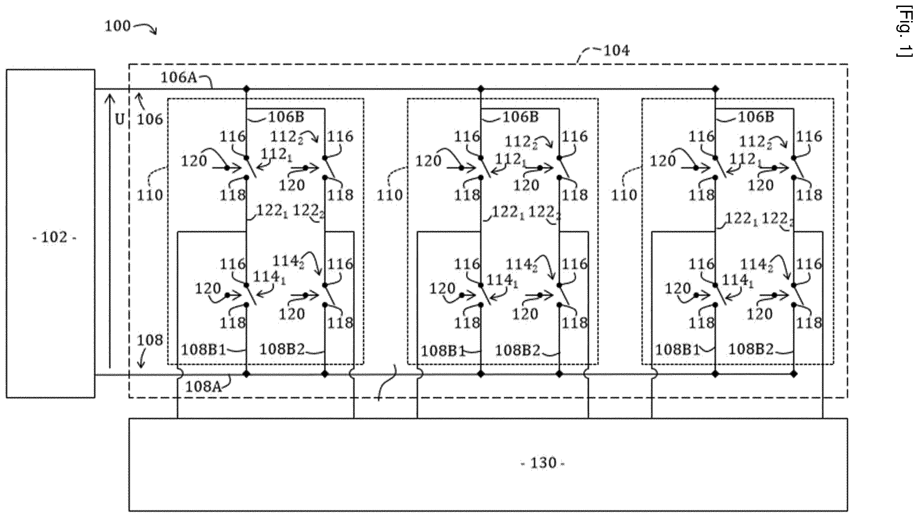

En référence à la figure 1, un système électrique 100 mettant en œuvre l'invention dans un premier mode de réalisation de l'invention va à présent être décrit.

Le système électrique 100 est par exemple destiné à être implanté dans un véhicule automobile.

Le système électrique 100 comporte tout d'abord une source d'alimentation électrique 102 conçue pour délivrer une tension continue U, par exemple comprise entre 10 V et 100 V, par exemple 48 V ou bien 12 V.

La source d'alimentation électrique 102 est donc une source de tension continue. Cette source d'alimentation électrique comporte par exemple une batterie.

Le système électrique 100 comporte en outre une machine électrique 130 comportant plusieurs phases (non représentées) destinées à présenter des tensions de phase respectives.

Le système électrique 100 comporte en outre un convertisseur de tension 104 connecté entre la source d'alimentation électrique 102 et la machine électrique 130 pour effectuer une conversion entre la tension continue U et les tensions de phase.

Le convertisseur de tension 104 comporte tout d'abord une barre omnibus positive 106 et une barre omnibus négative 108 destinées à être connectées à la source d'alimentation électrique 102 pour recevoir la tension continue U, la barre omnibus positive 106 recevant un potentiel électrique haut et la barre omnibus négative 108 recevant un potentiel électrique bas.

Le convertisseur de tension 104 comporte en outre au moins un module de puissance 110. Le module de puissance 110 comporte une ou plusieurs barres omnibus de phase destinées être respectivement connectées à une ou plusieurs phases de la machine électrique 130, pour fournir leurs tensions de phase respectives.

Dans l'exemple décrit, le convertisseur de tension 104 comporte trois modules de puissance 110 comportant chacun deux barres omnibus de phase $122_1$, $122_2$ connectées à deux phases de la machine électrique 130.

Plus précisément, dans l'exemple décrit, la machine électrique 130 comporte deux systèmes triphasés comportant chacun trois phases, et destinés à être électriquement déphasés de 120° l'un par rapport à l'autre. De préférence, les premières barres omnibus de phase $122_1$ des modules de puissance 110 sont respectivement connectées aux trois phases du premier système triphasé, tandis que les deuxièmes barres omnibus de phase $122_2$ des modules de puissance 110 sont respectivement connectées aux trois phases du deuxième système triphasé.

Chaque module de puissance 110 comporte, pour chaque barre omnibus de phase $122_1$, un premier composant électrique, (ici un interrupteur de côté haut $112_1$) connecté entre la barre omnibus positive 106 et la barre omnibus de phase $122_1$ et un deuxième composant électrique (ici un interrupteur de côté bas $114_1$), connecté entre la barre omnibus de phase $122_1$ et la barre omnibus négative 108. Ainsi, les interrupteurs $112_1$, $114_1$ sont agencés de manière à former un bras de commutation, dans lequel la barre omnibus de phase $122_1$ forme un point milieu.

Chaque module de puissance 110 comporte également, pour chaque barre omnibus de phase $122_2$, un troisième composant électrique (ici un interrupteur de côté haut $112_2$) connecté entre la barre omnibus positive 106 et la barre omnibus de phase $122_2$ et un quatrième composant électrique (ici un interrupteur de côté bas $114_2$) connecté entre la barre omnibus de phase $122_2$ et la barre omnibus négative 108. Ainsi, les interrupteurs $112_2$, $114_2$ sont agencés de manière à former un bras de commutation, dans lequel la barre omnibus de phase $122_2$ forme un point milieu.

Chaque interrupteur $112_1$, $114_1$, $112_2$, $114_2$ comporte des première et deuxième bornes principales 116, 118 et une borne de commande 120 destinée à sélectivement ouvrir et fermer l'interrupteur $112_1$, $114_1$, $112_2$, $114_2$ entre ses deux bornes principales 116, 118 en fonction d'un signal de commande qui lui est appliqué. Les interrupteurs $112_1$, $114_1$, $112_2$, $114_2$ sont de préférence des transistors, par exemple des transistors à effet de champ à structure métal-oxyde-semiconducteur (de l'anglais « Metal Oxide Semiconductor Field Effect Transistor » ou MOSFET) présentant une grille formant la borne de commande 120, et un drain et une source formant respectivement les bornes principales 116, 118. Alternativement, les interrupteurs $112_1$, $114_1$, $112_2$, $114_2$ pourraient être des transistors bipolaires à grille isolée (de l'anglais « Insulated Gate Bipolar Transistor » ou IGBT).

Dans l'exemple décrit, les interrupteurs $112_1$, $114_1$, $112_2$, $114_2$ ont chacun la forme d'une plaque, par exemple sensiblement rectangulaire, présentant une face supérieure et une face inférieure. La première borne principale 116 s'étend sur la face inférieure, tandis que la deuxième borne principale 118 s'étend sur la face supérieure. Les interrupteurs $112_1$, $114_1$, $112_2$, $114_2$ sont destinés à être traversés, entre leurs bornes principales 116, 118, par un courant supérieure à 1 A.

Il sera apprécié que la barre omnibus positive 106, la barre omnibus négative 108 et les barres omnibus de phase $122_1$, $122_2$ sont des conducteurs électriques rigides conçus pour supporter les courants électriques d'au moins 1 A destinés à traverser les interrupteurs $112_1$, $114_1$, $112_2$, $114_2$. Elles présentent de préférence une épaisseur d'au moins 1 mm.

Par ailleurs, dans l'exemple décrit, la barre omnibus positive 106 comporte tout d'abord une barre omnibus commune positive 106A reliant les modules de puissance 110 et, dans chaque module de puissance 110, une barre omnibus locale positive 106B connectée à la barre omnibus commune positive 106A. De manière similaire, la barre omnibus négative 108 comporte une barre omnibus commune négative 108A reliant les modules de puissance 110 et, dans chaque module de puissance 110, une barre omnibus locale négative 108B1, 108B2 pour chaque interrupteur de côté bas $114_1$, $114_2$, les barres omnibus locales négatives 108B1, 108B2 étant connectées à la barre omnibus commune négative 108A. Les connexions sont représentées sur la figure par des losanges.

En outre, dans l'exemple décrit, la barre omnibus commune positive 106A et la barre omnibus commune négative 108A sont chacune formée d'une seule pièce conductrice.

En outre, dans l'exemple décrit, la machine électrique 130 est une machine électrique tournante ayant a à la fois une fonction d'alternateur et de moteur électrique. Plus précisément, le véhicule automobile comporte en outre un moteur thermique (non représenté) présentant un axe de sortie auquel la machine électrique 130 est reliée par une courroie (non représentée). Le moteur thermique est destiné à entraîner des roues du véhicule automobile par l'intermédiaire de son axe de sortie. Ainsi, en fonctionnement comme alternateur, la machine électrique 130 fournit de l'énergie électrique en direction de la source d'alimentation électrique 102 à partir de la rotation de l'axe de sortie. Le convertisseur de tension 104 fonctionne alors comme redresseur. En fonctionnement comme moteur électrique, la machine électrique entraîne l'arbre de sortie (en complément ou bien à la place du moteur thermique). Le convertisseur de tension 104 fonctionne alors comme onduleur.

La machine électrique 130 est par exemple localisée dans une boîte de vitesses ou bien dans un embrayage du véhicule automobile ou bien en lieu et place de l'alternateur.

Dans la suite de la description, la structure et la disposition des éléments du convertisseur de tension 104 vont être décrits plus en détails, en référence à une direction verticale H-B, « H » représentant le haut et « B » représentant le bas. Cette direction verticale H-B étant notée sur les figures par la référence V.

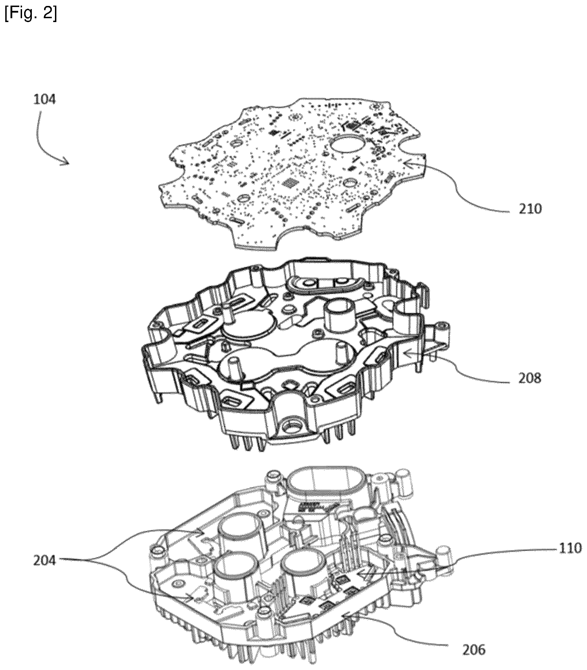

En référence à la figure 2, le convertisseur de tension 104 comprend un dissipateur thermique 206, également appelé dissipateur de chaleur, présentant des surfaces d'échange thermique 204 sur lesquelles sont respectivement montés les modules de puissance 110 (un seul module de puissance 110 est représenté sur la figure 2). L'échange thermique entre la surface d'échange thermique 204 du dissipateur thermique 206 et le module de puissance 110 est réalisé par exemple grâce à un contact, direct ou par l'intermédiaire d'une pate conductrice thermiquement, entre la surface d'échange thermique 204 du dissipateur thermique 206 et le module de puissance 110.

Le convertisseur de tension 104 comprend également un boitier support 208 sur lequel est fixé un module électronique secondaire comme un module de contrôle 210. Dans l'exemple de la figure 1, le module de contrôle 210 est une carte de contrôle. En outre et de façon optionnelle, le boitier support 208 est monté sur le dissipateur thermique 206.

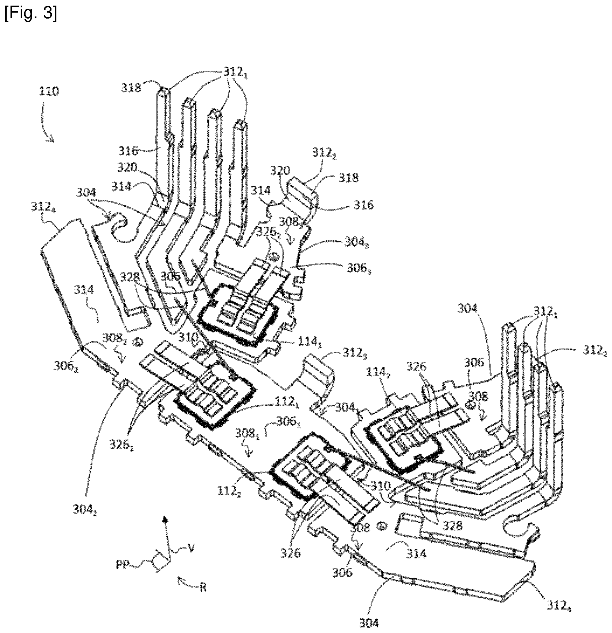

En référence à la figure 3, nous allons maintenant décrire le module de puissance 110.

Ce module de puissance 110 comporte plusieurs pièces de connexion électrique 304, $304_1$, $304_2$, $304_3$ de préférence en métal.

Chaque pièce de connexion électrique 304, $304_1$, $304_2$, $304_3$ présente une plaque principale 306, $306_1$, $306_2$, $306_3$ s'étendant selon un plan principal PP horizontal, le même pour toutes les plaques principales 306, $306_1$, $306_2$, $306_3$ de manière à ce que les plaques principales 306, $306_1$, $306_2$, $306_3$ soient sensiblement coplanaires. En particulier, dans l'exemple décrit, les plaques principales 306, $306_1$, $306_2$, $306_3$ présentent des faces supérieures 308, $308_1$, $308_2$, $308_3$ horizontales respectives s'étendant au même niveau. Par soucis de clarté, les faces supérieures 308, $308_1$, $308_2$, $308_3$ ne sont indiquées sur la figure que pour les plaques principales 306, $306_1$, $306_2$, $306_3$ les plus grandes.

En particulier, le module de puissance 110 comporte une première pièce de connexion électrique $304_1$ ayant une plaque principale $306_1$ présentant une face supérieure $308_1$, une deuxième pièce de connexion électrique $304_2$ ayant une plaque principale $306_2$ présentant une face supérieure $308_2$ et une troisième pièce de connexion électrique $304_3$ ayant une plaque principale $306_3$ présentant une face supérieure $308_3$.

Par ailleurs, les plaques principales 306, $306_1$, $306_2$, $306_3$ sont séparées les unes des autres selon le plan principal PP par au moins un interstice 310. Dans l'exemple décrit, chaque interstice 310 présente une largeur inférieure ou égale à un cinq millimètres. Cela signifie que les deux plaques principales délimitant l'interstice 310 sont distantes d'au plus cinq millimètres le long de cet interstice 310.

De manière générale, au moins une des pièces de connexion électrique 304 (toutes dans l'exemple décrit) présente en outre au moins un connecteur électrique se projetant depuis sa plaque principale 306, $306_1$, $306_2$, $306_3$. Chaque connecteur électrique est par exemple soit sous la forme d'une broche $312_1$, soit sous la forme d'une languette pliée $312_2$, $312_3$, soit encore sous la forme d'une languette droite $312_4$.

Dans l'exemple décrit ici, les languettes droites $312_4$ forment avec leurs plaques principales $306_2$, 306 les barres omnibus de phase $122_1$, $122_2$, la languette pliée $312_3$ forme avec sa plaque principale $306_1$ la barre omnibus locale positive 106B et les languettes pliées $312_2$ forment avec leurs plaques principales $306_3$, 306 les barres omnibus locales négatives 108B1, 108B2.

Chaque connecteur électrique $312_1$, $312_2$, $312_3$ présente une extrémité fixe 314 fixée à la plaque principale 306, $306_2$, $306_3$, $306_1$, une portion principale 316 s'étendant verticalement dans l'exemple décrit et se terminant par une extrémité libre 318 et un coude 320 reliant l'extrémité fixe 314 à la portion principale 316. Par soucis de clarté, ces différents éléments des connecteurs électriques $312_1$, $312_2$, $312_3$ ne sont indiqués sur la figure que pour deux connecteurs électriques $312_1$, $312_2$, l'un en forme de broche, l'autre en forme de languette.

Dans le cas d'une languette droite, le connecteur électrique $312_4$ se projette dans le plan principal PP sur une grande longueur afin de permettre sa connexion, par exemple au moins un centimètre. En outre, le connecteur électrique $312_4$ présente une extrémité fixe 314 fixée à la plaque principale 306, cette extrémité fixe 314 ayant une grande largeur pour permettre le passage de courant, par exemple d'au moins un centimètre.

Les pièces de connexion électrique 304 sont obtenues dans l'exemple décrit par découpage d'une plaque métallique.

Dans l'exemple décrit ici, la plaque métallique est en cuivre. En variante, la plaque métallique pourrait être en aluminium ou encore en or.

Par ailleurs, comme expliqué précédemment, le module de puissance 110 comporte des transistors $112_1$, $112_2$, $114_1$, $114_2$ chacun connecté électriquement entre deux faces supérieures 308, $308_1$, $308_2$, $308_3$ de

respectivement deux des plaques principales $306$, $306_1$, $306_2$, $306_3$ par exemple pour faire passer et interrompre sur commande un courant de puissance, pouvant par exemple être supérieure à un ampère entre ces deux plaques principales $306$, $306_1$, $306_2$, $306_3$. Chaque transistor $112_1$, $112_2$, $114_1$, $114_2$ présente tout d'abord une face inférieure plaquée contre l'une des deux faces supérieures $308$, $308_1$, $308_2$ auxquelles ce transistor est connecté électriquement. Chaque transistor $112_1$, $112_2$, $114_1$, $114_2$ présente en outre une face supérieure dont une partie est connecté électriquement à l'autre des deux faces supérieures. Dans l'exemple décrit, la face supérieure du transistor $112_1$, $112_2$, $114_1$, $114_2$ comporte en outre une partie de commande du transistor $112_1$, $112_2$, $114_1$, $114_2$, connectée électriquement à une face supérieure d'une troisième plaque principale $306$, par exemple par un fil $328$ dans l'exemple décrit.

En d'autres termes, le transistor $112_1$ est monté sur, et connecté électriquement à la face supérieure $308_1$ de la plaque principale $306_1$ de la première pièce de connexion électrique $304_1$ et un premier élément de liaison électrique connecte électriquement le transistor $112_1$ à la face supérieure $308_2$ de la plaque principale $306_2$ de la deuxième pièce de connexion électrique $304_2$.

Le premier élément de liaison électrique comprend deux rubans $326_1$, une extrémité de chaque ruban en métal $326_1$ est soudée sur la face supérieure $308_2$ de la plaque principale $306_2$ de la deuxième pièce de connexion électrique $304_2$ par un procédé de soudage. La deuxième extrémité de chaque ruban en métal $326_1$ est soudée directement sur le transistor $112_1$ par un procédé de soudage. Les procédés de soudage employés sont par exemple des procédés de soudage par ultrason ou par friction.

Dans l'exemple décrit ici, les deux rubans $326_1$ ont sensiblement la même forme.

De même, le transistor $114_1$ est monté sur, et connecté électriquement à la face supérieure $308_2$ de la plaque principale $306_2$ de la deuxième pièce de connexion électrique $304_2$ et un deuxième élément de liaison électrique connecte électriquement le transistor $114_1$ à la face supérieure $308_3$ de la plaque principale $306_3$ de la troisième pièce de connexion électrique $304_3$.

Le deuxième élément de liaison électrique comprend deux rubans $326_2$, une extrémité de chaque ruban en métal $326_2$ est soudée sur la face supérieure $308_3$ de la plaque principale $306_3$ de la troisième pièce de connexion électrique $304_3$ par un procédé de soudage. La deuxième extrémité de chaque ruban en métal $326_2$ est soudée directement sur le transistor $114_1$ par un procédé de soudage. Les procédés de soudure employés sont par exemple des procédés de soudage par ultrason ou par friction.

De façon similaire, les transistors $112_2$ et $114_2$ sont montés sur, et connectés électriquement à la face supérieure $308$, $308_1$ de la plaque principale $306$, $306_1$ d'une pièce de connexion électrique $304$, $304_1$ et ont leur face supérieure connectée électriquement à une faces supérieures d'une autre plaque principale $306$ au moyen de deux rubans de forme identique $326$.

Dans l'exemple décrit, les rubans $326$, $326_1$, $326_2$ sont en aluminium et présente par exemple une section de 2mmx0.3mm. Dans une variante de réalisation, les rubans $326$, $326_1$, $326_2$ sont en or.

Dans l'exemple décrit, le fil $328$ est en aluminium et présente un diamètre de 0.2mm Dans une variante de réalisation, le fil $328$ est en or.

Dans l'exemple décrit, les connecteurs électriques $312_1$ en forme de broche servent à la connexion du module de puissance 110 au module de contrôle 210, afin de faire des mesures de grandeurs électriques et de commander les transistors $112_1$, $112_2$, $114_1$, $114_2$.

En outre, toujours dans l'exemple décrit, les connecteurs électriques $312_2$ sont connectés à la barre omnibus commune négative 108A et le connecteur électrique $312_3$ est connecté à la barre omnibus commune positive 106A.

En outre, toujours dans l'exemple décrit, les deux connecteurs électriques $312_4$ en forme de languette droite forment respectivement les deux barres omnibus de phase $122_1$, $122_2$ du module de puissance 110.

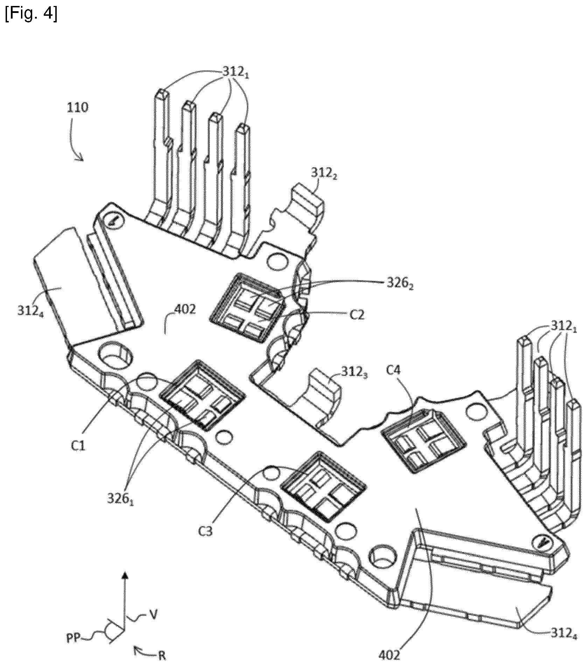

En référence à la figure 4, le surmoulage du module de puissance 110 est représenté et porte la référence 402.

Le surmoulage 402 est un isolant électrique et recouvre totalement chaque transistor $112_1$, $112_2$, $114_1$, $114_2$ et au moins une partie des faces supérieures $308_1$, $308_2$, $308_3$, $308$ des plaques principales $306_1$, $306_2$, $306_3$, $306$.

Dans l'exemple décrit ici, le surmoulage 402 recouvre également totalement chaque fil $328$.

En outre, la face supérieure du surmoulage isolant électrique 402 présente une première cavité C1 située au moins partiellement au-dessus de la partie la plus élevée du premier élément de liaison électrique.

Cette première cavité C1 est par exemple au moins partiellement découpée par ablation laser dans la face supérieure du surmoulage isolant électrique 402. De par sa réalisation, le fond de la première cavité C1 est plat, par exemple constitué de plusieurs marches situées à des niveaux différents, à l'exception d'une portion en saillie, s'élevant depuis le fond plat de la première cavité, située sous chacun des deux rubans $326_1$.

Une partie des rubans $326_1$ est ainsi située dans la première cavité C1 et le surmoulage isolant électrique 402 recouvre le reste des rubans $326_1$. En d'autres termes, le surmoulage isolant électrique 402 recouvre partiellement les rubans $326_1$ de sorte que seule la partie la plus élevée, par rapport à la direction haut-bas, des rubans $326_1$ n'est pas recouverte par le surmoulage isolant électrique 402 et est en outre située dans la première cavité C1.

De cette façon, le surmoulage isolant électrique exerce peu voire aucune force de maintien sur la partie la plus élevée des rubans $326_1$ ce qui permet une rupture facile de ces rubans lorsque ces rubans s'échauffent.

De même, la face supérieure du surmoulage isolant électrique 402 présente une deuxième cavité C2 située au moins partiellement au-dessus de la partie la plus élevée du deuxième élément de liaison électrique $326_2$.

Une partie des rubans $326_2$ est ainsi située dans la deuxième cavité C2 et le surmoulage isolant électrique 402 recouvre le reste des rubans $326_2$. En d'autres termes, le surmoulage isolant électrique 402 recouvre partiellement les rubans $326_2$ de sorte que seule la partie la plus élevée, par rapport à la direction haut-bas, des rubans $326_2$ n'est pas recouverte par le surmoulage isolant électrique 402 et est en outre située dans la deuxième cavité C2.

Pour les mêmes raisons que précédemment, le surmoulage isolant électrique 402 exerce peu voire aucune force de maintien sur la partie la plus élevée des rubans $326_2$ ce qui permet une rupture facile de ces rubans lorsque ces rubans s'échauffent.

Enfin, la face supérieure du surmoulage isolant électrique 402 présente également une troisième cavité C3 et une quatrième cavité C4 située respectivement au moins partiellement au-dessus des rubans 326 du transistor 1122 et du transistor 1142 et suffisamment profonde de sorte que seule la partie supérieure des rubans 326 du transistor 1122 et la partie supérieure des rubans 326 du transistor 1142 soient situées respectivement dans la troisième cavité C3 et dans la quatrième cavité C4 et de sorte que le surmoulage isolant électrique 402 recouvre le reste des rubans 326.

Le surmoulage 402 est par exemple en résine, par exemple encore en époxy. De préférence, le surmoulage 402 est intégral en une seule pièce.

Dans le mode de réalisation décrit ici, les cavités sont dépourvues de matière. En variante, les cavités sont remplies d'un gel, par exemple diélectrique et/ou en silicone. Le gel peut également avoir une viscosité se situant entre 230 et 600 mPa-s, de préférence entre 400 et 500 mPa-s, par exemple de 465 mPa-s et/ou une dureté comprise entre 65 et 180g, de préférence entre 110 et 160g, par exemple de 123g ou de 154g.

Dans une autre variante, les cavités sont remplies d'une résine différente de la résine formant le surmoulage isolant électrique 402. En particulier, la résine remplissant les cavités possède une dureté moindre que celle formant le surmoulage isolant électrique 402. Par exemple, le surmoulage isolant électrique 402 est formé d'une résine époxy, ayant par exemple une dureté entre 70 et 90 shore et les cavités sont remplies d'une résine élastomère, ayant par exemple une dureté entre 20 et 40 shore. La résine remplissant les cavités peut également appartenir à la classe de feu UL 94 V-0, telle que définie par la compagnie de certification Underwriters Laboratories.

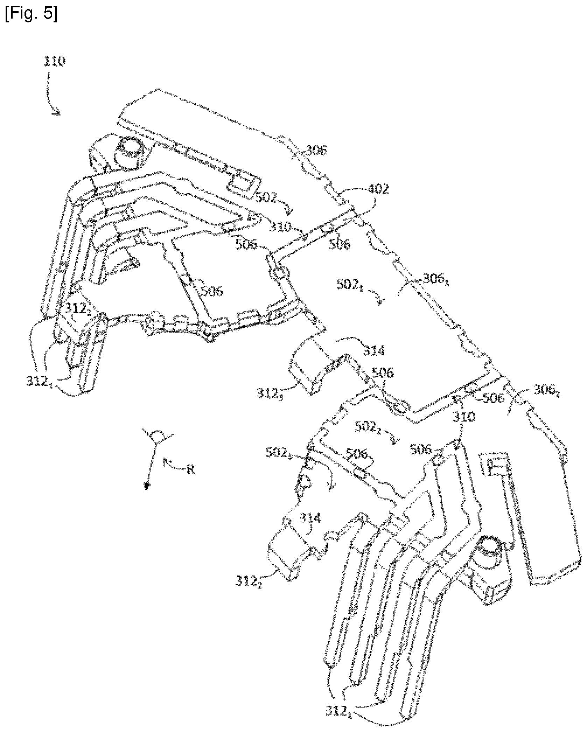

La figure 5 est une vue de dessous du module de puissance 110.

Comme cela est visible sur cette figure, le surmoulage 402 laisse apparent la face inférieure $502_1$ de la plaque principale $306_1$ de la première pièce de connexion électrique $304_1$. Cette partie laissée apparente est conçue pour être plaquée contre le dissipateur thermique 206. Ainsi, le dissipateur thermique 206 est en contact thermique avec la face inférieure $502_1$ laissée apparente par le surmoulage 402. Ce contact thermique peut être un contact direct ou bien via un élément de liaison électrique isolant et thermiquement conducteur.

De même surmoulage 402 laisse apparent les faces inférieures 502, 5022, $502_3$ des plaque principale 306, $306_2$, $306_3$ de chacune des autres pièces de connexion électrique 304, 3042, $304_3$. Ces parties laissées apparentes sont conçues pour être plaquée contre le dissipateur thermique 206. Ainsi, le dissipateur thermique 206 est en contact thermique avec les faces inférieures 502, 5022, $502_3$ laissées apparentes par le surmoulage 402. Ce contact thermique peut être un contact direct ou bien via un élément de liaison électrique isolant et thermiquement conducteur.

En outre, le surmoulage 402 remplit chaque interstice 310 et présente, dans chaque interstice 310, une face inférieure affleurant les faces inférieures 502 des plaques principales 206.

Le surmoulage 402 présente au moins un plot en résine 506 se projetant vers le bas et conçu pour venir au contact direct du dissipateur thermique 206 afin de définir un écartement prédéfini entre les faces inférieures 502, $502_1$, 5022, $502_3$ des plaques principales 306, $306_1$, $306_2$, $306_3$ et le dissipateur thermique 206, et ainsi l'épaisseur de l'élément conducteur thermique remplissant cet écartement. Dans l'exemple décrit, chaque plot en résine 506 se projette depuis la face inférieure du surmoulage présent dans l'un des interstices 310 entre les plaques principales 306, $306_1$, $306_2$, $306_3$.

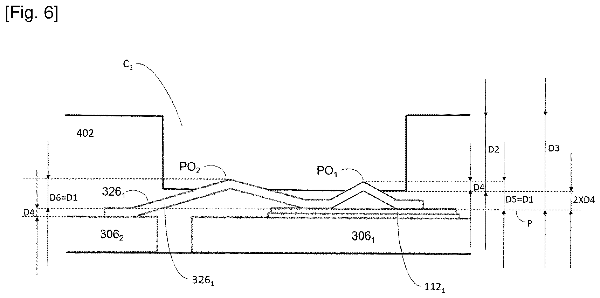

La figure 6 présente une vue partielle du module de puissance 110 selon un plan de coupe perpendiculaire au plan principale PP et passant par l'axe principal d'un des rubans du premier élément de liaison électrique.

Notons tout d'abord que la face supérieure du premier transistor $112_1$ définit un plan de référence P.

Les deux rubans identiques $326_1$ forment chacun un premier pont $PO_1$ et un deuxième pont $PO_2$.

Les deux extrémités du premier pont $PO_1$ reposent à plat sur la face supérieure du premier transistor $112_1$. La projection orthogonale du point le plus élevé du premier pont $PO_1$ sur le plan de référence P est incluse dans la projection orthogonale du fond plat de la première cavité C1 sur le plan de référence P.

Une extrémité du deuxième pont $PO_2$ repose à plat sur la face supérieure du premier transistor $112_1$ et l'autre extrémité du deuxième pont $PO_2$ repose à plat sur la face supérieure de la plaque principale $306_2$ de la deuxième pièce de connexion électrique 3042. La projection orthogonale du point le plus élevé du deuxième pont $PO_2$ sur le plan de référence P est incluse dans la projection orthogonale du fond plat de la première cavité C1 sur le plan de référence P.

Dans l'exemple décrit ici, les deux ponts $PO_1$

et $PO_2$ des deux rubans $326_1$ ont la même élévation. Il s'en suit que la projection orthogonale du point le plus élevé de chaque ruban $326_1$ sur le plan de référence est incluse dans la projection orthogonale du fond plat de la cavité sur le plan de référence (P).

Nous allons maintenant mettre en évidence les relations existantes entre les dimensions physiques des rubans $326_1$, du surmoulage 402 et de la première cavité C1.

Dans la description qui suit, les élévations sont définies par rapport à la dimension haut-bas préalablement décrite.

La distance D2 est la distance entre le plan parallèle au plan de référence passant par le point le plus élevé du surmoulage isolant électrique 402 et le plan parallèle au plan de référence P passant par le point le moins élevé de la première cavité C1.

La distance D3 est la distance entre le plan parallèle au plan de référence P passant par le point le plus élevé du surmoulage isolant électrique 402 et le plan de référence P.

La distance D4 correspond à l'épaisseur identique de chacun des deux rubans $326_1$.

Ces distances D2, D3 et D4 sont configurées de sorte que la différence entre les distances D3 et D2 soit supérieure ou égale à deux fois la distance D4. En d'autres termes, les distances D3, D2 et D4 vérifient l'équation :

[Math. 1]

$$D3 - D2 \geq 2D4$$

Grâce à cette relation mathématique, l'existence d'une épaisseur de résine minimale au-dessus du premier transistor $112_1$ est garantie se sorte que le premier transistor soit correctement protégé par la résine.

En outre, cette épaisseur de résine minimale garantie également que le premier transistor $112_1$ ne risque pas d'être endommagé lors de la réalisation par ablation laser de la première cavité C1.

En outre, si on définit la distance D5 comme la distance entre le point le plus élevé du premier pont $PO_1$ par rapport au plan de référence P, alors les distances D5, D2, D3, D4 sont en outre configurées de sorte que la différence entre la distance D5 et la distance D4 soir supérieure ou égale à la différence entre la distance D3 et la distance D2.

En d'autres termes, les distances D2, D3, D4 et D5 vérifient l'équation :

[Math. 2]

$$D5 - D4 \geq D3 - D2$$

De même, si on définit la distance D6 comme la distance entre le point le plus élevé du deuxième pont $PO_2$ par rapport au plan de référence P, alors les distances D6, D2, D3, D4 sont en outre configurées de sorte que la différence entre la distance D6 et la distance D4 soir supérieure ou égale à la différence entre la distance D3 et la distance D2.

En d'autres termes, les distances D2, D3, D4 et D6 vérifient l'équation :

[Math. 3]

$$D6 - D4 \geq D3 - D2$$

Grâce à ces relations mathématiques, les extrémités supérieures des deux pont $PO_1$ et $PO_2$ se situent dans la première cavité C1 de sorte que le surmoulage 402 exerce peu ou pas de pression sur ces extrémités supérieures.

Dans l'exemple décrit les deux ponts $PO_1$ et $PO_2$ ont la même élévation de sorte que les distances D5 et D6 sont égales. Les distances D5 et D6 sont également égale à la distance D1 entre le point le plus élevé de chacun des deux rubans de forme identique $326_1$ par rapport au plan de référence P.

En d'autres termes, les distances D1, D3, D2 et D4 vérifient l'équation :

[Math. 4]

$$D1 - D4 \geq D3 - D2$$

Bien évidemment, des relations identiques existent entre les dimensions physiques des rubans $326_2$, du surmoulage 402 et de la deuxième cavité C2, de même qu'entre les dimensions physiques des rubans 326, du surmoulage 402 et des cavités C3 et cavité C4.

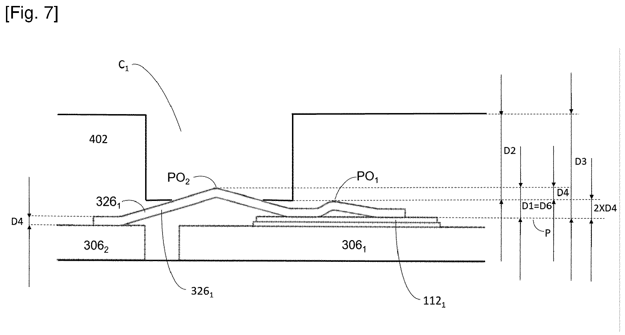

En référence à la figure 7, nous allons maintenant décrire un deuxième mode de réalisation de l'invention. Les éléments identiques, ou analogues à ceux du premier mode de réalisation portent la même référence numérique dans la description du deuxième mode de réalisation.

Ce deuxième mode de réalisation se différentie du premier par la forme des rubans $326_1$ et par les dimensions de la première cavité C1.

De façon plus précise, pour les des deux rubans $326_1$, le deuxième pont $PO_2$ à une élévation supérieure à celle du premier pont $PO_1$ et la première cavité C1 est réalisée de sorte que le premier pont $PO_1$ soit entièrement recouvert de résine.

Comme pour le premier mode de réalisation, les distances D2, D3 et D4 sont configurées de sorte que la différence entre les distances D3 et D2 soit supérieure ou égale à deux fois la distance D4. En d'autres termes, les distances D3, D2 et D4 vérifient l'équation Math. 1

En outre, les distances D2, D3, D4 et D6 vérifient l'équation Math. 3.

Bien évidemment, dans ce deuxième mode de réalisation, des relations identiques existent entre les dimensions physiques des rubans $326_2$, du surmoulage 402 et de la deuxième cavité C2, de même qu'entre les dimensions physiques des rubans 326, du surmoulage 402 et des cavités C3 et C4.

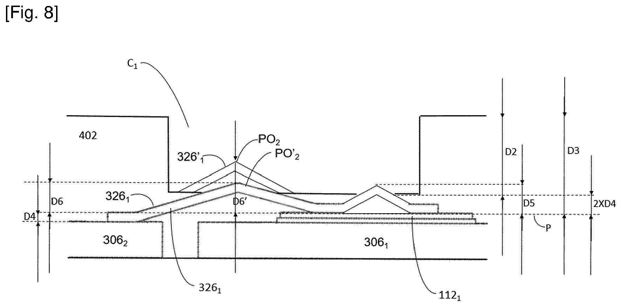

En référence à la figure 8, nous allons maintenant décrire un troisième mode de réalisation de l'invention. Les éléments identiques, ou analogues à ceux du premier ou du deuxième mode de réalisation portent la même référence numérique dans la description de ce troisième mode de réalisation.

Ce troisième mode de réalisation se différentie du premier par le fait que les deux rubans ne sont pas identiques.

Ainsi, le deuxième pont $PO'_2$ d'un des deux rubans $326'_1$ à une élévation supérieure à celle du deuxième pont $PO_2$ de l'autre ruban $326_1$.

Comme cela est visible sur la figure, la projection orthogonale du point le plus élevé de chaque ruban $326_1$, $326'_1$ sur le plan de référence P est incluse dans la projection orthogonale du fond plat de la première cavité C1 sur le plan de référence P et pour chaque ruban $326_1$, $326'_1$, la différence entre la distance entre le point le plus élevé D6, D6, de ce ruban par rapport au plan de référence P et l'épaisseur D4 de ce ruban est supérieure ou égale à la différence entre la distance D3 et la distance D2.

On notera par ailleurs que l'invention n'est pas limitée aux modes de réalisation décrits précédemment. Il apparaîtra en effet à l'homme de l'art que diverses modifications peuvent être apportées aux modes de réalisation décrits ci-dessus, à la lumière de l'enseignement qui vient de lui être divulgué.

Par exemple, tous les rubans ou certains des rubans 326, $326_1$, $326_2$ pourraient être remplacés par des fils et/ou des fusibles.

Par exemple encore, les transistors $112_1$, $114_1$, 1122, 1142 pourraient être des transistors FET ou HEMT en nitrure de gallium.

En outre, dans les modes de réalisation précédemment décrits, les éléments de liaison électrique possèdent chacun des rubans. En variante, ces éléments de liaison électrique pourraient ne posséder qu'un seul ruban. Dans une autre variante ces éléments de liaison électrique pourraient posséder au moins trois rubans.

Dans la présentation détaillée de l'invention qui est faite précédemment, les termes utilisés ne doivent pas être interprétés comme limitant l'invention aux modes de réalisation exposés dans la présente description, mais doivent être interprétés pour y inclure tous les équivalents dont la prévision est à la portée de l'homme de l'art en appliquant ses connaissances générales à la mise en œuvre de l'enseignement qui vient de lui être divulgué.

**Revendications**

1. Module de puissance (110) comprenant :

   - une première ($304_1$) et une deuxième ($304_2$) pièces de connexion électrique, de préférence en métal, présentant chacune une plaque principale ($306_1$, $306_2$), les plaques principales ($306_1$, $306_2$) s'étendant selon un même plan principal (PP) de manière à être sensiblement coplanaires ;
   - un transistor ($112_1$) monté sur une face supérieure de la plaque principale ($306_1$) de la première pièce de connexion électrique ($304_1$), la face supérieure du transistor ($112_1$) définissant un plan de référence (P), ledit transistor ($112_1$) étant connecté électriquement par au moins un rubans ($326_1$) ou par un au moins un fil à la face supérieure de la plaque principale ($306_2$) de la deuxième pièce de connexion électrique ($304_2$) ; et
   - un surmoulage isolant électrique (402), par exemple en résine, recouvrant ledit transistor ($112_1$) et au moins une partie de la face supérieure de la plaque principale ($306_1$, $306_2$) de la première ($304_1$) et de la deuxième ($304_2$) pièces de connexion électrique, la face supérieure du surmoulage isolant électrique (402) présentant une cavité (C1) située au moins partiellement au-dessus du ruban ($326_1$) ou du fil ;

   ledit module de puissance (110) étant **caractérisé en ce que** ladite cavité (C1) est à fond plat, **en ce que** le ruban ($326_1$) ou le fil forme un premier pont ($PO_1$) dont les deux extrémités reposent à plat sur la face supérieure du transistor ($112_1$), **en ce que** la projection orthogonale du point le plus élevé du premier pont ($PO_1$) sur le plan de référence (P) est incluse dans la projection orthogonale dudit fond plat de la cavité (C1) sur le plan de référence (P) et dans lequel la différence entre la distance D5 entre le point le plus élevé du premier pont ($PO_1$) par rapport au plan de référence (P) et l'épaisseur (D4) du ruban ($326_1$) ou du fil est supérieure ou égale à la différence entre la distance D3 entre le plan parallèle au plan de référence passant par ledit point le plus élevé du surmoulage isolant électrique (402) et le plan de référence (P) et la distance D2 entre le plan parallèle au plan de référence passant par le point le plus élevé du surmoulage isolant électrique (402) et le plan parallèle au plan de référence passant par le point le moins élevé de ladite cavité (C1).

2. Module de puissance (110) selon la revendication précédente dans lequel la différence entre la distance D3 et la distance D2 est supérieure ou égale à l'épaisseur (D4) du ruban ou du fil, de préférence supérieure ou égale à deux fois l'épaisseur du ruban ou du fil.

3. Module de puissance (110) selon l'une des revendications précédentes dans lequel ladite cavité (C1) est à fond plat, ledit module de puissance (110) étant **caractérisé en ce que** la projection orthogonale du point le plus élevé du ruban ($326_1$) ou du fil sur le plan de référence (P) soit incluse dans la projection orthogonale dudit fond plat sur le plan de référence (P) et **en ce que** la différence entre la distance D1 entre le point le plus élevé du ruban ($326_1$) ou du fil par rapport au plan de référence (P) et l'épaisseur du ruban ou du fil (D4) soit supérieure ou égale à la différence entre la distance D3 et la distance D2.

4. Module de puissance (110) selon l'une des revendications précédentes dans lequel ledit ruban ($326_1$) ou fil forme un deuxième pont ($PO_2$) dont une extrémité repose à plat sur la face supérieure du transistor ($112_1$) et dont l'autre extrémité repose à plat sur la supérieure de la plaque principale ($306_2$) de la deuxième pièce de connexion électrique (3042), dans lequel la projection orthogonale du point le plus élevé du deuxième pont ($PO_2$) sur le plan de référence (P) est incluse dans la projection orthogonale dudit fond plat de la cavité (C1) sur le plan de référence (P) et dans lequel la différence entre la distance D6 entre le point le plus élevé du deuxième pont ($PO_2$) par rapport au plan de référence (P) et l'épaisseur (D4) du ruban ou du fil est supérieure ou égale à la différence entre la distance D3 et la distance D2.

5. Module de puissance (110) selon l'une des revendications précédentes dans lequel ledit transistor ($112_1$) est connecté par une pluralités de rubans ($326_1$) et/ou de fils à la face supérieure de la plaque principale ($306_2$) de la deuxième pièce de connexion électrique ($304_2$) et dans lequel ladite cavité (C1) est à fond plat, ledit module de puissance (110) étant **caractérisé en ce que** la projection orthogonale du point le plus élevé de chaque ruban ($326_1$) et/ou fil sur le plan de référence (P) soit incluse dans la projection orthogonale du fond plat de la cavité (C1) sur le plan de référence (P) et **en ce que** pour chaque ruban ($326_1$) et/ou fil, la différence entre la distance ($D6_1$, $D6_2$) entre le point le plus élevé de ce ruban et/ou fil par rapport au plan de référence (P) et l'épaisseur (D4) de ce ruban ($326_1$) ou fil soit supérieure ou égale à la différence entre la distance D3 et la distance D2

6. Module de puissance (110) selon l'une des revendications précédentes dans lequel ladite cavité (C1) a été au moins partiellement découpée par ablation laser dans la face supérieure du surmoulage isolant électrique (402).

7. Module de puissance (110) selon l'une des revendications précédentes dans lequel le surmoulage (402) laisse apparent au moins une partie de la face inférieure ($502_1$, $502_2$) de la plaque principale ($306_1$, $306_2$) d'au moins une des pièces de connexion électrique ($304_1$, 3042), cette partie laissée apparente étant conçue pour être plaquée contre un dissipateur thermique (206).

8. Système électrique (100) comprenant un dissipateur thermique (206) et un module de puissance selon la revendication précédente, et dans lequel le dissipateur thermique (206) est en contact thermique avec la face inférieure laissée apparente par le surmoulage (402).

9. Convertisseur de tension (104) comprenant un module de puissance (110) selon l'une quelconque des revendications 1 à 7 ou bien un système électrique (100) selon la revendication 8.

[Fig. 1]

[Fig. 2]

[Fig. 3]

[Fig. 4]

[Fig. 5]

[Fig. 6]

[Fig. 7]

[Fig. 8]

Europäisches
Patentamt

European
Patent Office

Office européen
des brevets

**RAPPORT DE RECHERCHE EUROPEENNE**

Numéro de la demande

**EP 21 21 4254**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | US 2015/206830 A1 (TAKADA KEITA [JP] ET AL) 23 juillet 2015 (2015-07-23) * alinéas [0086], [0089], [0096], [0102], [0113], [0114], [0123]; figure 6 * | 1-9 | INV.<br>H01L21/56<br>H01L23/31<br>H01L23/485<br>H01L23/495<br>H02M7/00 |
| Y | EP 1 034 555 B1 (INFINEON TECHNOLOGIES AG [DE]) 30 janvier 2002 (2002-01-30) * alinéas [0001], [0002], [0003], [0014], [0022] – [0026]; figures 1, 2 * | 1-9 | ADD.<br>H02M7/5387 |
| Y | JP 2013 038238 A (RICOH CO LTD) 21 février 2013 (2013-02-21) * alinéas [0015], [0016]; figures 1c, 2c, 2d * | 5 | |
| Y | US 2007/075050 A1 (HEYL JON [US]) 5 avril 2007 (2007-04-05) * alinéas [0049], [0071]; figures 6A-b to 6F-b, 9A * | 6-8 | |
| Y | FR 3 068 564 A1 (VALEO EQUIP ELECTR MOTEUR [FR]) 4 janvier 2019 (2019-01-04) * page 5, ligne 11 – ligne 28; figures 1, 6, 7 * | 9 | DOMAINES TECHNIQUES RECHERCHES (IPC)<br><br>H01L |
| A | JP H06 84993 A (NEC YAMAGATA LTD) 25 mars 1994 (1994-03-25) * figure 1B * | 1-9 | |
| A | JP 2008 177424 A (TOSHIBA CORP) 31 juillet 2008 (2008-07-31) * figure 2a * | 1-9 | |
| A | US 10 756 072 B2 (INTEL CORP [US]) 25 août 2020 (2020-08-25) * le document en entier * | 5 | |

Le présent rapport a été établi pour toutes les revendications

| Lieu de la recherche | Date d'achèvement de la recherche | Examinateur |
|---|---|---|
| Munich | 9 mai 2022 | Ronnås, Katharina |

EPO FORM 1503 03.82 (P04C02)

## ANNEXE AU RAPPORT DE RECHERCHE EUROPEENNE
## RELATIF A LA DEMANDE DE BREVET EUROPEEN NO.

EP 21 21 4254

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

09-05-2022

| Document brevet cité au rapport de recherche | Date de publication | Membre(s) de la famille de brevet(s) | Date de publication |
|---|---|---|---|
| US 2015206830 A1 | 23-07-2015 | CN 104603943 A | 06-05-2015 |
| | | HK 1206147 A1 | 31-12-2015 |
| | | JP 5870200 B2 | 24-02-2016 |
| | | JP WO2014045435 A1 | 18-08-2016 |
| | | KR 20150056531 A | 26-05-2015 |
| | | TW 201413839 A | 01-04-2014 |
| | | US 2015206830 A1 | 23-07-2015 |
| | | WO 2014045435 A1 | 27-03-2014 |
| EP 1034555 B1 | 30-01-2002 | DE 19752196 C1 | 11-02-1999 |
| | | EP 1034555 A1 | 13-09-2000 |
| | | JP 2001524735 A | 04-12-2001 |
| | | WO 9927554 A1 | 03-06-1999 |
| JP 2013038238 A | 21-02-2013 | AUCUN | |
| US 2007075050 A1 | 05-04-2007 | US 2007075050 A1 | 05-04-2007 |
| | | WO 2007005636 A2 | 11-01-2007 |
| FR 3068564 A1 | 04-01-2019 | AUCUN | |
| JP H0684993 A | 25-03-1994 | AUCUN | |
| JP 2008177424 A | 31-07-2008 | AUCUN | |
| US 10756072 B2 | 25-08-2020 | TW 201739022 A | 01-11-2017 |
| | | US 2018374832 A1 | 27-12-2018 |
| | | WO 2017107176 A1 | 29-06-2017 |

EPO FORM P0460

Pour tout renseignement concernant cette annexe : voir Journal Officiel de l'Office européen des brevets, No.12/82